# EUROPEAN PATENT SPECIFICATION

(11) **EP 3 030 700 B1**
(45) Date of publication and mention of the grant of the patent: **28.11.2018**
(21) Application number: 14834159.7
(22) Date of filing: 05.08.2014
(51) Int. Cl.: C30B 29/40, C30B 9/00, C30B 19/02, C30B 19/06, C30B 9/10

(54) **METHOD FOR MANUFACTURING GROUP 13 NITRIDE CRYSTAL**
VERFAHREN ZUR HERSTELLUNG VON GRUPPE-13-NITRIDKRISTALLEN
PROCÉDÉ DE FABRICATION DE CRISTAL DE NITRURE D'ÉLÉMENT DU GROUPE 13

(30) Priority: 08.08.2013 JP 2013165083
(43) Date of publication of application: 15.06.2016
(73) Proprietor: Ricoh Company, Ltd., Tokyo 143-8555 (JP)
(72) Inventor: SATOH, Takashi, Tokyo 143-8555 (JP); SARAYAMA, Seiji, Tokyo 143-8555 (JP); HAYASHI, Masahiro, Tokyo 143-8555 (JP); WADA, Junichi, Tokyo 143-8555 (JP)
(74) Representative: J A Kemp
(86) International application number: PCT/JP2014/071135
(87) International publication number: WO 2015/020226

(56) References cited:
- WO-A1-2005/080648
- JP-A- 2009 263 162
- JP-A- 2010 180 085
- JP-A- 2011 213 579
- JP-A- 2012 091 958
- US-A1- 2002 092 464
- US-A1- 2003 164 138
- US-A1- 2010 260 656

## Description

### TECHNICAL FIELD

The present invention relates to a method for manufacturing a group 13 nitride crystal, and in particular, to a technique for manufacturing a group 13 nitride single crystal such as gallium nitride and aluminum nitride.

### BACKGROUND ART

A flux method is known as a method for manufacturing group 13 nitride crystals. In the flux method, a source gas such as a nitrogen gas is dissolved in a mixed melt (flux) containing an alkali metal or an alkali-earth metal and a group 13 metal to reach a supersaturated state, thereby causing a group 13 nitride crystal to grow on a spontaneous nucleus or with a seed crystal as a nucleus in the mixed melt.

In the flux method, the source gas dissolves into the mixed melt from the vapor-liquid interface between the mixed melt and the source gas. The concentration of a solute (nitrogen) in the mixed melt thus tends to increase near the vapor-liquid interface, which is likely to cause solute concentration distribution within the mixed melt. Such solute concentration distribution causes deterioration in the quality of a crystal.

A method in which a mixed melt is stirred through shaking or rotation is known as a method for reducing the solute concentration distribution within the mixed melt (Patent Literatures 1 and 2). A technique is also disclosed in which a structure such as a baffle and a propeller is installed within a mixed melt and is rotated to stir the mixed melt. For example, Patent Literature 3 discloses a method in which a baffle or the like is installed within a reaction vessel, and a mixed melt is stirred so as to create a flow from its vapor-liquid interface toward the inside of the raw material. Patent Literature 4 discloses a method in which a seed crystal holder holding a seed crystal is installed in a reaction vessel and is rotated.

Patent Literature 5 discloses a method in which a large-sized gallium nitride crystal is grown from a seed crystal in a rotating reaction vessel comprising structures to provide for a mixing of the melt.

However, in the crystal growth of a group 13 nitride crystal from a seed crystal by a flux method, the crystal itself comes to have an effect similar to a baffle or the like by the crystal growing to increase in size and stir a mixed melt along with the rotation of a reaction vessel. Due to this, turbulence of a flow may be produced in the mixed melt depending on the installation positions of the baffle and the seed crystal and cause the group 13 nitride crystal to grow into a polycrystal or cause miscellaneous crystals to precipitate.

When assuming that the growth time of the crystals would be about a few to a few dozen hours as in Patent Literatures 1 and 3, it can be said that a crystal size is comparatively small and adverse effects due to the stirring effect of the grown crystal itself as mentioned above are comparatively small. However, the needs for a high-quality, large-sized group 13 nitride single crystal have increased in recent years. To meet such needs, it is necessary to maintain stable crystal growth over a few hundred hours. The crystal size increases in such a crystal growth process over a long time, resulting in enhancement of the above adverse effects due to the stirring effect of the grown crystal itself. Therefore, it is extremely difficult to manufacture a high-quality, large-sized crystal by the conventional method as described above.

In view of the above, there is a need to provide a high-quality, large-sized group 13 nitride single crystal.

### SUMMARY OF THE INVENTION

A method is for manufacturing a group 13 nitride crystal by a flux method. The method includes: placing a seed crystal and a mixed melt that contains an alkali metal or an alkali-earth metal and a group 13 element in a reaction vessel; and rotating the reaction vessel to stir the mixed melt. The reaction vessel includes a structure to stir the mixed melt. More than one seed crystals are installed point-symmetrically with respect to a central axis of the reaction vessel at positions other than the central axis such that a c plane of each of the seed crystals is substantially parallel to a bottom of the reaction vessel. The structure is installed point-symmetrically with respect to the central axis at at least part of the reaction vessel other than the central axis.

### BRIEF DESCRIPTION OF DRAWINGS

FIG. 1 is a diagram illustrating the overall configuration of an apparatus for manufacturing a group 13 nitride crystal according to an embodiment.
FIG. 2 is a diagram illustrating the internal configuration of a pressure-resistant vessel according to the present embodiment.
FIG. 3 is a diagram illustrating a first example of a seed crystal according to the present embodiment.
FIG. 4 is a diagram illustrating a second example of a seed crystal according to the present embodiment.
FIG. 5 is a diagram illustrating a third example of a seed crystal according to the present embodiment.
FIG. 6 is a diagram illustrating a fourth example of a seed crystal according to the present embodiment.
FIG. 7 is a diagram illustrating a fifth example of a seed crystal according to the present embodiment.
FIG. 8 is a diagram illustrating a sixth example of a seed crystal according to the present embodiment.
FIG. 9 is a diagram illustrating a first example of the installation method of seed crystals and a structure according to the present embodiment.
FIG. 10 is a sectional view taken along the line X-X of FIG. 9.
FIG. 11 is a diagram illustrating a second example of the installation method of seed crystals and structures according to the present embodiment.
FIG. 12 is a sectional view taken along the line XII-XII of FIG. 11.
FIG. 13 is a diagram illustrating a third example of the installation method of seed crystals and structures according to the present embodiment.
FIG. 14 is a diagram illustrating an improper example of the installation method of seed crystals and structures.
FIG. 15 is a sectional view taken along the line XIV-XIV of FIG. 13.
FIG. 16 is a graph illustrating a first example of rotation control according to the present embodiment.
FIG. 17 is a graph illustrating a second example of rotation control according to the present embodiment.

### DESCRIPTION OF EMBODIMENTS

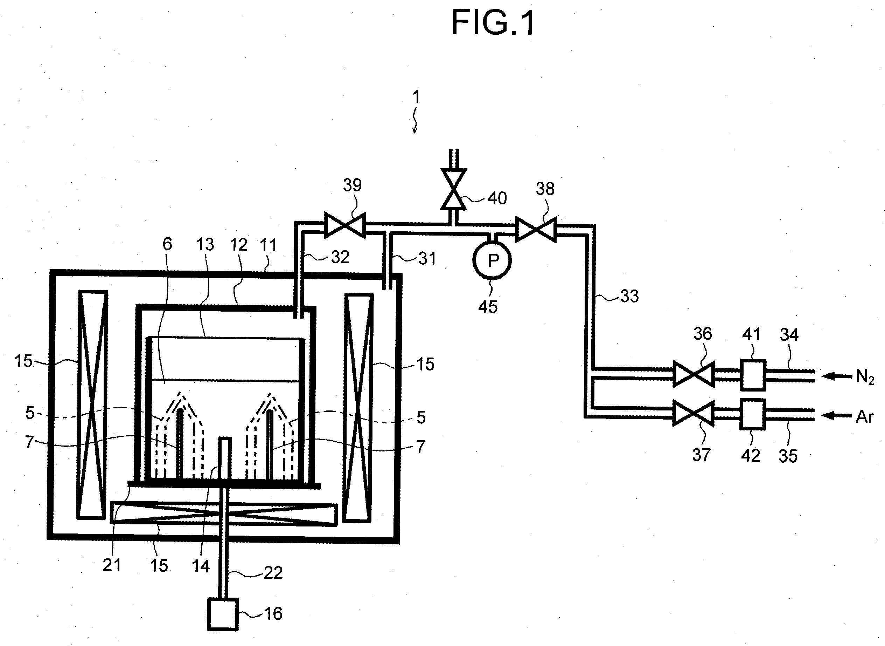

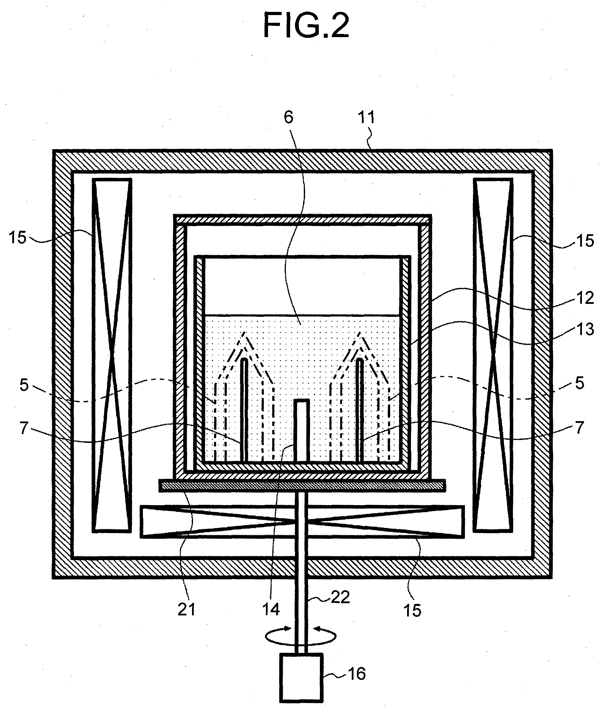

The following describes an embodiment according to the present invention in detail with reference to the accompanying drawings. FIG. 1 illustrates the overall configuration of a manufacturing apparatus 1 for a group 13 nitride crystal according to the present embodiment. FIG. 2 illustrates the internal configuration of a pressure-resistant vessel 11 of the manufacturing apparatus 1. FIG. 2 omits pipes 31, 32 that introduce gases from outside the pressure-resistant vessel 11 illustrated in FIG. 1 for the sake of convenience.

The manufacturing apparatus 1 is an apparatus for manufacturing group 13 nitride crystals 5 by the flux method. The pressure-resistant vessel 11 is, for example, made of stainless steel. An internal vessel 12 is installed within the pressure-resistant vessel 11. A reaction vessel 13 is further housed within the internal vessel 12.

The reaction vessel 13 is a vessel for holding a mixed melt (flux) 6 and seed crystals 7 and growing the group 13 nitride crystals 5. A structure 14 for stirring the mixed melt 6 is installed within the reaction vessel 13 (the structure 14 is described in detail below).

Examples of the material of the reaction vessel 13 include, but not limited to, nitrides such as boron nitride (BN) sintered bodies and pyrolytic BN (P-BN), oxides such alumina and yttrium aluminum garnet (YAG), and carbides such as SiC. It is preferable that the inner wall face of the reaction vessel 13, that is, the part at which the reaction vessel 13 comes into contact with the mixed melt 6 be made of a material resistant to reaction with the mixed melt 6. Examples of the material may include nitrides such as BN, P-BN, and aluminum nitride, oxides such as alumina and YAG, and stainless steel (SUS).

The mixed melt 6 is a melt containing an alkali metal or an alkali-earth metal and a group 13 element. Examples of the alkali metal include at least one selected from sodium (Na), lithium (Li), and potassium (K). Preferable is sodium or potassium. Examples of the alkali-earth metal include at least one selected from calcium (Ca), magnesium (Mg), strontium (Sr), and barium (Ba). Examples of the group 13 element includes at least one selected from boron (B), aluminum (Al), gallium (Ga), indium (In), and thallium (Tl). Preferable is gallium. Representative examples of the mixed melt 6 include a Ga-Na mixed melt.

The seed crystals 7 are placed inside the reaction vessel 13 so as to be immersed in the mixed melt 6. In the present embodiment, the seed crystals 7 are fixed to the bottom of the reaction vessel 13. The seed crystals 7 are nitride crystals serving as nuclei of the crystal growth of the group 13 nitride crystals 5 (the seed crystals 7 are described in detail below).

The internal vessel 12 is installed on a turntable 21 within the pressure-resistant vessel 11 in an attachable and detachable manner. The turntable 21 is fixed to a rotational shaft 22 and is rotatable by a rotational mechanism 16 arranged outside the pressure-resistant vessel 11. The rotational mechanism 16 rotates the rotational shaft 22 by a motor or the like. The rotational velocity, rotational direction, and the like of the rotational shaft 22 are controlled by a control unit including a computer operating in accordance with a computer program, various kinds of logic circuits, and/or the like (the control of the rotational shaft 22 is described in detail below). The internal vessel 12, the reaction vessel 13, the structure 14, and the like rotate along with the rotation of the rotational shaft 22. The members that rotate along with the rotation of the rotational shaft 22 are not limited to these. For example, a heater 15 may further rotate, or only the reaction vessel 13 may rotate. Through the rotation of the seed crystals 7 and the structure 14 along with the rotation of the reaction vessel 13, the mixed melt 6 is stirred.

A source gas containing nitrogen is supplied into the pressure-resistant vessel 11. As illustrated in FIG. 1, the pipes 31, 32 that supply a nitrogen (N₂) gas as a raw material of the group 13 nitride crystals 5 and a diluent gas for total pressure adjustment are connected to the internal space of the pressure-resistant vessel 11 and the internal space of the internal vessel 12, respectively. A pipe 33 branches into two pipes 34, 35. The pipe 34 supplies a nitrogen gas and the pipe 35 supplies a diluent gas. Valves 36, 37 are provided at the pipes 34, 35, respectively. The diluent gas is preferably an argon (Ar) gas as an inert gas, but is not limited thereto and may be, for example, helium (He) or neon (Ne).

The nitrogen gas flows into the pipe 34 from a gas cylinder or the like, and the pressure thereof is adjusted by a pressure controller 41. The nitrogen gas then flows into the pipe 33 via the valve 36. The diluent gas flows into the pipe 35 from a gas cylinder or the like, and the pressure thereof is adjusted by a pressure controller 42. The diluent gas then flows into the pipe 33 via the valve 37. The thus pressure-adjusted nitrogen gas and diluent gas form a gas mixture within the pipe 33.

The gas mixture is supplied to the internal space of the pressure-resistant vessel 11 via a valve 38 and the pipe 31 and is supplied to the internal space of the internal vessel 12 via a valve 39 and the pipe 32, from the pipe 33. The internal space of the internal vessel 12 and the internal space of the reaction vessel 13 are connected with each other within the pressure-resistant vessel 11 and have nearly the same atmosphere and nearly the same pressure. The internal vessel 12 is detachable from the manufacturing apparatus 1. The pipe 31 is connected to the outside via the pipe 33 and a valve 40.

The pipe 33 has a pressure gauge 45. By monitoring the pressure gauge 45, the pressure of the internal spaces of the pressure-resistant vessel 11 and the internal vessel 12 (reaction vessel 13) can be adjusted. Thus, the pressures of the nitrogen gas and the diluent gas are adjusted with the valves 36, 37 and by the pressure controllers 41, 42, respectively. This enables the nitrogen partial pressure within the reaction vessel 13 to be adjusted. The total pressure in the pressure-resistant vessel 11 and the internal vessel 12 can be adjusted, and thus, the total pressure within the internal vessel 12 can be increased to suppress the vaporization of the mixed melt 6 (sodium, for example) within the reaction vessel 13. In other words, the nitrogen partial pressure having an influence on the crystal growth conditions of gallium nitride and the total pressure having an influence on the vaporization of the mixed melt 6 can be separately controlled. Obviously, only the nitrogen gas may be introduced into the reaction vessel without introducing the diluent gas. The overall configuration of the manufacturing apparatus 1 illustrated in FIG. 1 is merely an exemplification, and any alterations to, for example, the mechanism that supplies the gas containing nitrogen into the reaction vessel 13 have no influence on the technical scope of the present invention.

As illustrated in FIG. 1, the heater 15 is installed at the outer circumference of and under the bottom of the internal vessel 12 inside the pressure-resistant vessel 11. The heater 15 heats the internal vessel 12 and the reaction vessel 13 to adjust the temperature of the mixed melt 6.

Operation to charge the seed crystals 7, raw materials (the alkali metal or the alkali-earth metal and the group 13 element), additives such as C, and dopants such as Ge into the reaction vessel 13 may be performed with the internal vessel 12 put into a glove box having an atmosphere of an inert gas such as an argon gas. This operation may also be performed in the state where the reaction vessel 13 is placed in the internal vessel 12.

The molar ratio between the group 13 element and the alkali metal contained in the mixed melt 6 is not particularly limited and is preferably set such that the molar ratio of the alkali metal with respect to the total molar number of the group 13 element and the alkali metal is 40% to 95%.

After the raw materials and the like are thus charged, the heater 15 is energized to heat the internal vessel 12 and the reaction vessel 13 up to a crystal growth temperature. In doing so, the group 13 element, the alkali metal or the alkali-earth metal, other additives, and the like as the raw materials melt within the internal vessel 12 to produce the mixed melt 6. The source gas with a certain nitrogen partial pressure is brought into contact with the mixed melt 6, whereby nitrogen dissolves into the mixed melt 6. The raw materials thus dissolved into the mixed melt 6 are supplied to the surfaces of the seed crystals 7, and the crystal growth of the group 13 nitride crystals 5 proceeds.

In such a crystal growth process, the rotational mechanism 16 rotates the reaction vessel 13 to rotate the seed crystals 7 and the structure 14, thereby stirring the mixed melt 6. Thus, the nitrogen concentration distribution within the mixed melt 6 can be kept uniform. Crystal growth is performed for a long time in the mixed melt 6 with the uniform nitrogen concentration distribution. This enables high-quality, large-sized group 13 nitride crystals 5 to be manufactured.

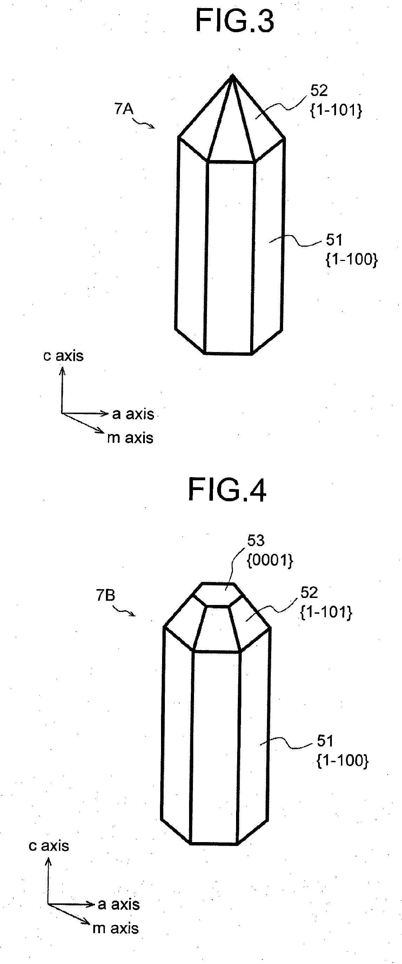

The following exemplifies the seed crystals 7 usable in the manufacturing apparatus 1 and the manufacturing method. FIGS. 3 to 8 illustrate first to sixth examples of the seed crystals 7, respectively. In these different examples, the same reference numerals may be provided to parts that produce the same or similar effect to omit duplicated description.

Seed crystals 7A, 7B according to the first and the second examples illustrated in FIGS. 3 and 4 are needle-like (columnar) crystals with a hexagonal cross section (see Japanese Patent Application Laid-open No. 2011-213579, for example). The seed crystals 7A, 7B each have six side faces ({1-100} plane) 51 and six inclined faces ({1-101} plane) 52. The seed crystal 7B further has a top face ({0001} plane) 53. Each of the side faces 51 and the inclined faces 52 serves as a main growth plane in the crystal growth process of a group 13 nitride crystal. The main growth plane is a main plane of the group 13 nitride crystal where it grows isotropically. The side faces 51 and the inclined faces 52 (the main growth planes of the seed crystals 7A, 7B) face toward the outer circumferential direction of the reaction vessel 13. Specifically, the side faces 51 face the outer circumferential surface of the reaction vessel 13 vertically substantially in parallel and the inclined faces 52 face the outer circumferential surface at a certain angle. During rotation, the seed crystals 7A, 7B having the main growth planes facing toward the outer circumferential direction of the reaction vessel 13 in this way come into collision with the mixed melt 6 in large areas to produce large stirring effects. The seed crystals 7A, 7B are thus suitable for the manufacturing apparatus 1 and the manufacturing method according to the present embodiment.

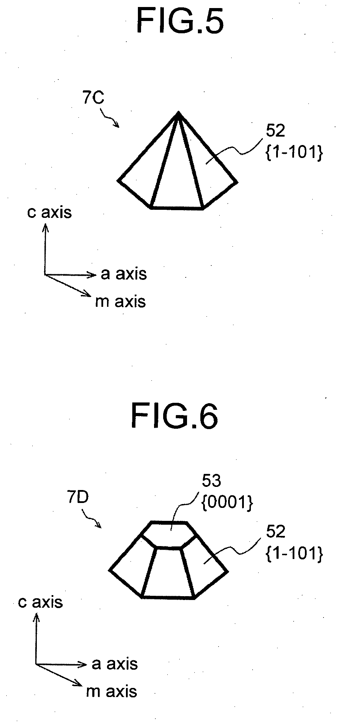

Seed crystals 7C, 7D according to the third and the fourth examples illustrated in FIGS. 5 and 6 are pyramidal crystals. The seed crystals 7C, 7D each have six inclined faces ({1-101} plane) 52. The seed crystal 7D further has a top face ({0001} plane) 53. Each of the inclined faces 52 serves as the main growth plane and faces toward the outer circumferential direction of the reaction vessel 13. Specifically, the inclined faces 52 face the outer circumferential surface of the reaction vessel 13 at a certain angle. Although the seed crystals 7C, 7D have no main growth plane facing the outer circumferential surface of the reaction vessel 13 in parallel, they have the main growth planes facing the outer circumferential surface at a certain angle. Stirring effects of a certain magnitude can be expected in such crystals. Thus, it can be said that the seed crystals 7C, 7D is suitable for the manufacturing apparatus 1 and the manufacturing method according to the present embodiment.

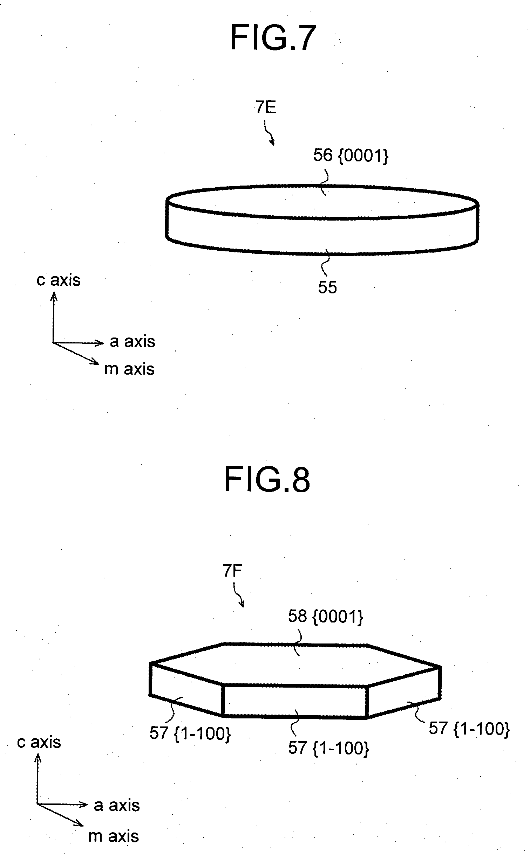

A seed crystal 7E according to a fifth example illustrated in FIG. 7 is a disk-like crystal. A seed crystal 7F according to a sixth example illustrated in FIG. 8 is a hexagonal plate-like crystal. The seed crystal 7E has a curved side face 55 and a top face ({0001} plane) 56. The seed crystal 7F has six side faces ({1-100} plane) 57 and a top face ({0001} plane) 58. The top faces 56, 58 serve as main growth planes. The main growth planes of such seed crystals 7E, 7F do not face toward the outer circumferential direction, and the stirring effects are small at the initial stage in the crystal growth process. However, the stirring effects increase in accordance with the increase in the thicknesses of the seed crystals 7E, 7F along with the crystal growth over a few hundred hours. Therefore, even the seed crystals 7E, 7F are applicable to the manufacturing apparatus 1 and the manufacturing method according to the present embodiment.

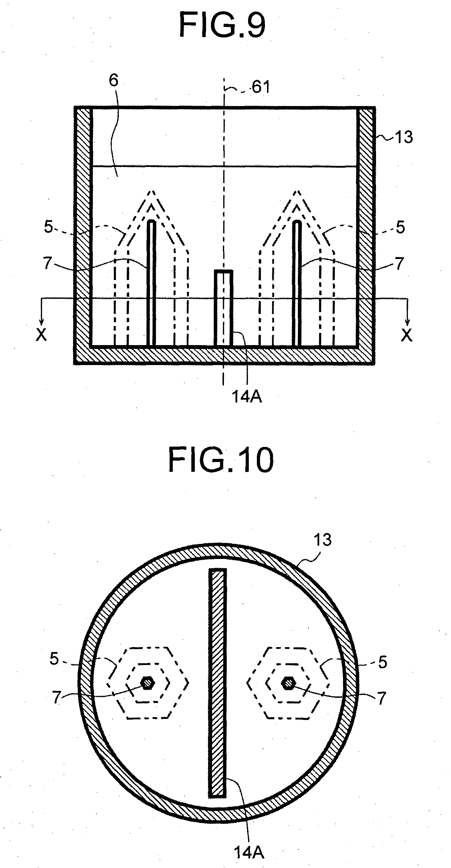

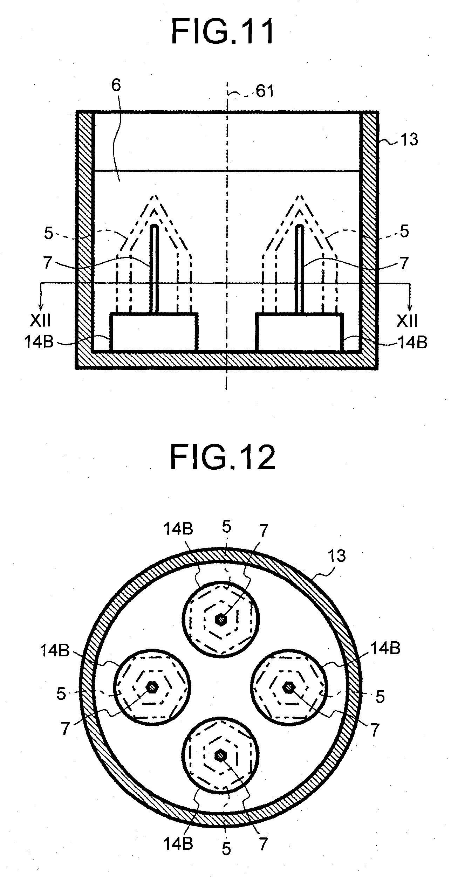

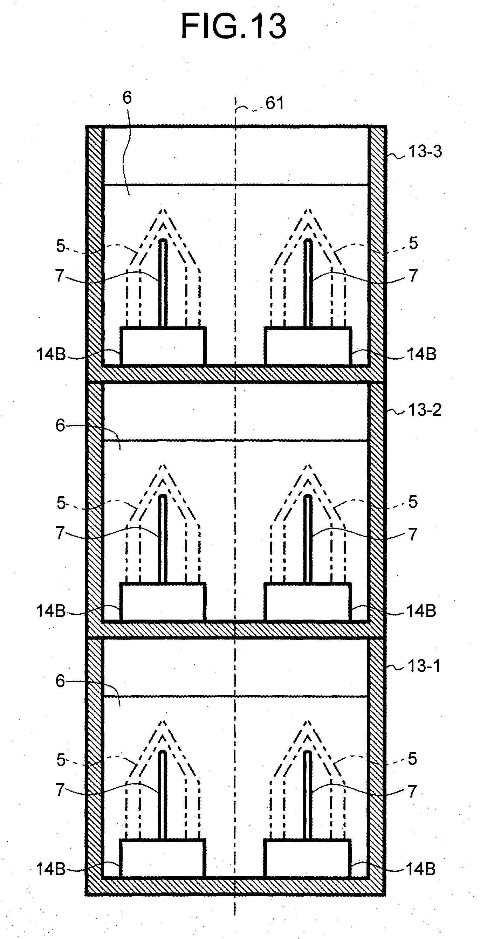

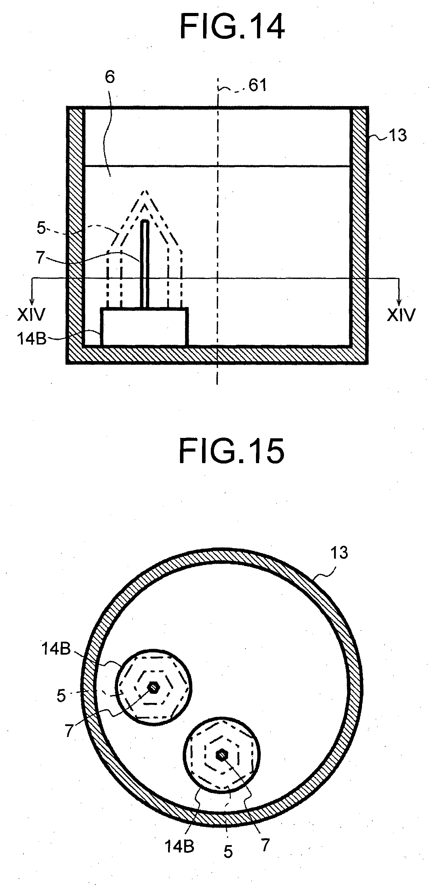

The following describes the installation method of the seed crystals 7 and the structure 14. FIGS. 9 and 10 illustrate a first example of the installation method of the seed crystals 7 and the structure 14. FIG. 10 is a sectional view taken along the line X-X of FIG. 9. FIGS. 11 and 12 illustrate a second example of the installation method of the seed crystals 7 and such structures 14. FIG. 12 is a sectional view taken along the line XII-XII of FIG. 11. FIG. 13 illustrates a third example of the installation method of the seed crystals 7 and the structures 14. FIGS. 14 and 15 illustrate an improper example of the installation method of the seed crystals 7 and the structures 14. FIG. 15 is a sectional view taken along XIV-XIV of FIG. 14. In these different examples, the same reference numerals may be provided to parts that produce the same or similar effect to omit duplicated description.

In the first example of the installation method illustrated in FIGS. 9 and 10, two columnar seed crystals 7 are installed point-symmetrically with respect to a central axis 61 of the reaction vessel 13, and a plate-like structure 14A is installed point-symmetrically with respect to the central axis 61. Specifically, the plate-like structure 14A is installed such that it extends through the central axis 61 and the central axis 61 substantially coincides with the center of the structure 14A in the longitudinal direction of the structure 14A. The structure 14A is arranged upright so as to mark the boundary between the two seed crystals 7. Spacing is provided between both edges of the structure 14A and the inner wall of the reaction vessel 13.

In such a configuration, when the reaction vessel 13 is rotated and is then stopped, the mixed melt 6 comes into collision with the structure 14A to create vertical flows in the mixed melt 6, which makes the solute (nitrogen) concentration distribution in the mixed melt 6 uniform. When the sizes of the group 13 nitride crystals 5 gradually increase, the group 13 nitride crystals 5 themselves similarly act as the structure 14A. In other words, when the reaction vessel 13 is rotated and stopped, the vertical flows are created not only near the structure 14A but also near the group 13 nitride crystals 5 to further make the solute concentration distribution uniform. This enables highly uniform group 13 nitride crystals 5 to be produced.

The uniform solute concentration distribution of the mixed melt 6 allows the main growth planes of a plurality of seed crystals 7 to grow isotropically. Furthermore, the seed crystals 7 are installed point-symmetrically with respect to the central axis 61. Due to this configuration, even when the sizes of the group 13 nitride crystals 5 increase, the vertical flows created in the mixed melt 6 maintain the symmetry with respect to the central axis 61, and no turbulence of flows is caused in the mixed melt 6. This suppresses formation of polycrystals of the grown group 13 nitride crystals 5 and production of miscellaneous crystals.

The number of the seed crystals 7 and the structure 14A is not particularly limited so long as the symmetry of the seed crystals 7 and the structure 14A is ensured in the reaction vessel 13 as a whole, that is, so long as the seed crystals and the structure are arranged with the central axis as a symmetry center.

In the second example of the installation method illustrated in FIGS. 11 and 12, four columnar structures 14B are installed point-symmetrically with respect to the central axis 61 at the bottom of the reaction vessel 13, and four columnar seed crystals 7 are installed at the centers on the respective structures 14B. In the second example, the structures 14B and the seed crystals 7 are installed at positions that have fourfold symmetry with the central axis 61 as a symmetry center.

The seed crystals 7 thus installed on the structures 14B gradually increase the sizes of the group 13 nitride crystals 5. Even when the group 13 nitride crystals 5 themselves similarly act as the structures 14B, it does not change where vertical flows are created in the mixed melt 6. Vertical flows are created in the reaction vessel 13 while maintaining the symmetry and thus do not disturb flows of the mixed melt 6. As a result, no local highly supersaturated portion is produced, the group 13 nitride crystals 5 are not grown into polycrystals, and no miscellaneous crystal is produced. Moreover, by such installation of the seed crystals 7 on the structures 14B, the space in the reaction vessel 13 is effectively used, and a large number of group 13 nitride crystals 5 can be grown at the same time, which can increase the productivity. The number of the seed crystals 7 and the structures 14B is not particularly limited so long as the seed crystals 7 and the structures 14B are arranged symmetrically with the central axis as the center of symmetry in the reaction vessel 13. Furthermore, the positions of the seed crystals 7 and the structures 14B more preferably are rotationally symmetric.

In the third example of the installation method illustrated in FIG. 13, three reaction vessels 13-1, 13-2, 13-3 according to the second example are stacked. The reaction vessels 13-1, 13-2, 13-3 are stacked such that their central axes 61 are aligned with the rotational shaft 22 (see FIGS. 1 and 2), and all of the reaction vessels 13-1, 13-2, 13-3 rotate together along with the rotation of the rotational shaft 22.

A plurality of reaction vessels 13-1, 13-2, 13-3 are thus coaxially installed, whereby, similarly to the case where the reaction vessel 13 is used alone, the mixed melt 6 can be caused to sufficiently flow around all of the seed crystals 7 in all of the reaction vessels 13-1, 13-2, 13-3 at the same time. In doing so, a plurality of high quality group 13 nitride crystals 5 can be produced at the same time to further increase the productivity.

FIGS. 14 and 15 illustrate an improper example of the installation method of the seed crystals 7 and the structures 14B. In this example, the two structures 14B are asymmetrically installed with respect to the central axis 61, and the two seed crystals 7 are installed at the centers on the respective structures 14B.

In this configuration, when the reaction vessel 13 is rotated and stopped, upward flows from the outer region to the central region of the reaction vessel 13 are created asymmetrically with respect to the central axis 61 to produce turbulence of flows in the mixed melt 6. A solute concentration distribution is thereby caused and produces a local highly supersaturated portion. As a result, a part of the group 13 nitride crystals 5 may be grown into polycrystals, miscellaneous crystals may be additionally precipitated, and crystal growth rates may vary among the crystal growth planes.

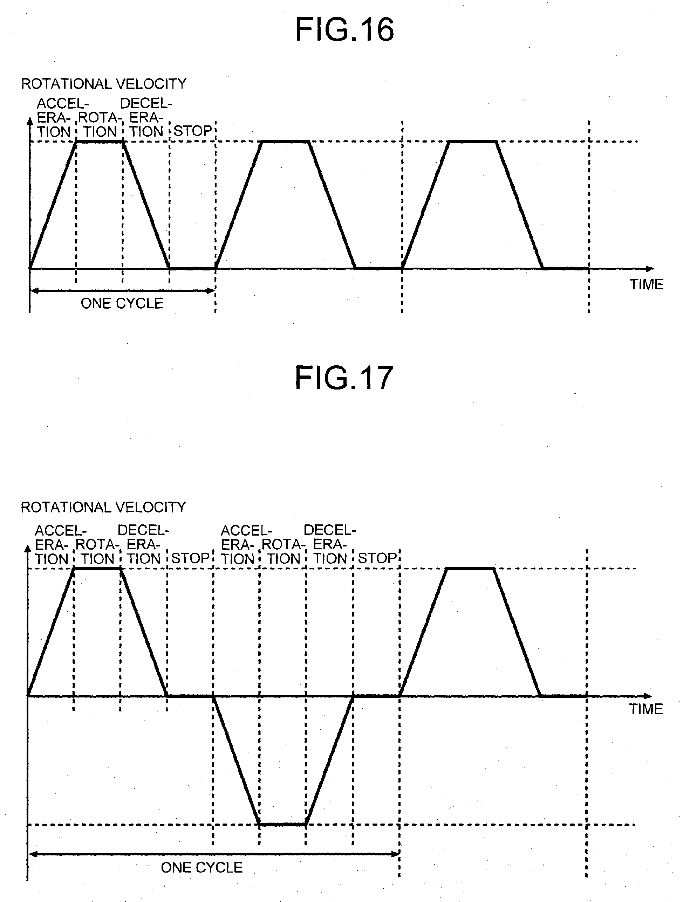

The following describes the rotation control of the rotational shaft 22 by the rotational mechanism 16. FIG. 16 illustrates a first example of the rotation control. FIG. 17 illustrates a second example of the rotation control.

When the seed crystals 7 and the structures 14 are rotated in one direction at a constant velocity, there is no relative velocity between the mixed melt 6 and the seed crystals 7 as well as the structures 14, and thus, ideal flows such as vertical flows are not created in the mixed melt 6. Therefore, it is preferable that rotation control be performed such that the seed crystals 7 and the structures 14 repeat rotation, stop, and the like, thereby causing the mixed melt 6 to have a relative velocity to the seed crystals 7 and the structures 14.

The rotation control according to the first example illustrated in FIG. 16 repeats one cycle consisting of acceleration in a first rotational direction from a stopped state, rotation at a predetermined velocity, deceleration from the predetermined velocity to a stopped state, and the hold of the stopped state. This rotation control is performed to cause the mixed melt 6 to have a relative velocity to the seed crystals 7 and the structures 14, thereby enabling an ideal vertical flow to be stably created and the mixed melt 6 to be stirred effectively. This first example repeats the rotation in a single direction.

The rotation control according to the second example illustrated in FIG. 17 repeats one cycle consisting of acceleration in a first direction from a stopped state, the hold of rotation at a predetermined velocity, deceleration from the predetermined velocity to a stopped state, the hold of the stopped state, acceleration in a second rotational direction opposite to the first rotational direction from the stopped state, rotation at a predetermined velocity, deceleration from the predetermined velocity to a stopped state, and the hold of the stopped state. This rotation control is performed to enable a vertical flow to be created all over the seed crystals 7 and enable the mixed melt 6 to be stirred more effectively than the first example illustrated in FIG. 16.

The following describes examples manufacturing the group 13 nitride crystals 5 by using the manufacturing apparatus 1 according to the present embodiment.

### Example 1

In the present example, a gallium nitride (GaN) crystal was grown as a group 13 nitride crystal in a condition where the seed crystals 7 and the structure 14A were installed as illustrated in FIGS. 9 and 10. First, columnar seed crystals 7A made of GaN as illustrated in FIG. 3 were installed in the reaction vessel 13 made of alumina in a glove box with a high-purity Ar atmosphere. The seed crystals 7A were inserted in holes formed in the bottom of the reaction vessel 13 to be held.

Next, sodium (Na) liquefied by heating was put into the reaction vessel 13 as the mixed melt (flux) 6. After the sodium solidified, gallium (Ga) and carbon were put thereinto. The molar ratio between gallium and sodium was set at 0.25:0.75. The carbon content was set at 0.5% with respect to the total molar number of gallium, sodium, and carbon.

After that, the reaction vessel 13 was housed inside the internal vessel 12, and the internal vessel 12 was taken out of the glove box and incorporated into the manufacturing apparatus 1. In this operation, the internal vessel 12 was installed on the turntable 21 inside the pressure-resistant vessel 11 such that the central axis 61 of the reaction vessel 13 was aligned with the rotational shaft 22 of the rotational mechanism 16.

The total pressure inside the internal vessel 12 was set at 2.2 MPa, and the heater 15 was energized to increase the temperature of the reaction vessel 13 to a crystal growth temperature. The temperature was set at 870°C, and the nitrogen gas pressure was set at 3.0 MPa in the crystal growth process. In this state, the reaction vessel 13 was intermittently rotated in one direction (see FIG. 16) to perform crystal growth for 1,000 hours. The rotational velocity in this situation was set at 15 rpm.

In doing so, when the reaction vessel 13 was rotated and then stopped, the mixed melt 6 came into collision with the structure 14A to create vertical flows in the mixed melt 6. As a result, the solute concentration distribution in the mixed melt 6 was made uniform. Moreover, as the sizes of the GaN crystals 5 gradually increased along with the crystal growth, the GaN crystals 5 themselves similarly acted as the structure 14A, and vertical flows were also created near the GaN crystals 5. The solute concentration distribution of the mixed melt 6 thus made uniform allowed the main growth planes of each of the seed crystals 7 to grow isotropically. The seed crystals 7 had been installed point-symmetrically with respect to the central axis 61 of the reaction vessel 13. Thus, even when the sizes of the GaN crystals 5 increased, vertical flows were created in the mixed melt 6 while maintaining the symmetry in the reaction vessel 13. As a result, no local highly supersaturated portion was produced, the GaN crystals 5 were not grown into polycrystals, and no miscellaneous crystal was additionally produced. When sizes of the GaN crystals 5 are enlarged along with the crystal growth, a larger stirring effect than that obtained by the structure 14A alone could be obtained. This allowed highly uniform crystals to be produced.

Through the crystal growth process, two bulky GaN crystals 5 having a length in the c axis direction of 65 mm and a length in a direction vertical to the c axis direction of 55 mm were able to be manufactured. No miscellaneous crystal was produced and the GaN crystals 5 were not grown into polycrystals. When the manufactured bulky GaN crystals 5 were each sliced in parallel with the m plane and the c plane, and X-ray diffraction (XRD) measurement was performed thereon, it was revealed that the GaN crystal 5 had small variations in the full width at half maximum (FWHM) and the peak position of X-ray rocking curve (XRC) across the entire m plane and the entire c plane. The FWHM of XRC for the GaN crystal 5 in this case was 30 ± 10 arcsec both in the m plane and the c plane. The dislocation density of the obtained crystal was as low as 10⁴ cm⁻² or less, and the crystal was of high quality.

### Example 2

In the present example, a GaN crystal 5 was grown in a condition where the seed crystals 7 and the structures 14B were installed as illustrated in FIGS. 11 and 12. The four columnar structures 14B were installed point-symmetrically with respect to the central axis 61 of the reaction vessel 13. Specifically, the structures 14B and the seed crystals 7 were installed at positions that have fourfold symmetry with the central axis 61 as the center of symmetry. The four columnar seed crystals 7A were installed at the centers on the respective structures 14B. The seed crystals 7A were inserted in holes formed in the structures 14 to be held. The other crystal growth conditions and rotation conditions were the same as those of Example 1.

In this configuration, even when the sizes of the GaN crystals 5 increased to such a degree that the GaN crystals 5 themselves similarly acted as the structures 14B, it did not change where vertical flows were created in the mixed melt 6. The vertical flows were created while maintaining the symmetry with respect to the central axis 61 in the reaction vessel 13. As a result, no local highly supersaturated portion was produced, the GaN crystals 5 were not grown into polycrystals, and no miscellaneous crystal was additionally produced. Moreover, by such installation of the seed crystals 7 on the structures 14B, the space in the reaction vessel 13 is effectively used, and the four GaN crystals 5 were able to be grown at the same time, which increased the productivity.

Through the crystal growth process, four bulky GaN crystals 5 having a length in the c axis direction of 65 mm and a length in a direction vertical to the c axis direction of 55 mm were able to be manufactured. No miscellaneous crystal was produced and the GaN crystals 5 were not grown into polycrystals. When the manufactured bulky GaN crystals 5 were each sliced in parallel with the m plane and the c plane, and XRD measurement was performed thereon, it was revealed that the GaN crystal 5 had small variations in the FWHM and the peak position of XRC across the entire m plane and the entire c plane. The FWHM of XRC for the GaN crystal 5 in this case was 30 ± 10 arcsec both in the m plane and the c plane. The dislocation density of the obtained crystal was as low as 10⁴ cm⁻² or less, and the crystal was of high quality.

### Example 3

In the present example, the GaN crystals 5 were grown in a manner similar to Example 2 except that the rotation control illustrated in FIG. 17 was performed. The seed crystals 7 and the structures 14B were installed in the reaction vessel 13 as illustrated in FIGS. 11 and 12. For the rotation control of the rotational shaft 22 to rotate the reaction vessel 13, a rotation method of a cycle consisting of acceleration, rotation, deceleration, and stop, followed by acceleration, rotation, deceleration, and stop in the direction opposite to the immediately preceding rotational direction was used as illustrated in FIG. 17. This cycle was repeated at a rotational velocity of 15 rpm for 1000 hours to grow the crystals.

The solute concentration distribution in the mixed melt 6 is further made uniform by reversing the rotational direction in this way, and more uniform GaN crystals 5 were able to be produced.

Through the crystal growth process, the bulky GaN crystals 5 having a length in the c axis direction of 65 mm and a length in a direction vertical to the c axis direction of 55 mm were able to be manufactured. No miscellaneous crystal was produced and the GaN crystals 5 were not grown into polycrystals. When the manufactured bulky GaN crystals 5 were each sliced in parallel with the m plane and the c plane, and XRD measurement was performed thereon, it was revealed that the GaN crystal 5 had small variations in the FWHM and the peak position of XRC across the entire m plane and the entire c plane. The FWHM of XRC for the GaN crystal 5 in this case was 25 ± 5 arcsec both in the m plane and the c plane. The dislocation density of the obtained crystal was as low as 10⁴ cm⁻² or less, and the crystal was of high quality.

### Example 4

In the present example, three of the reaction vessels 13 (13-1, 13-2, 13-3) illustrated in FIGS. 11 and 12 were stacked, and GaN crystals 5 were grown. The reaction vessels 13-1, 13-2, 13-3 were stacked such that the central axis 61 was aligned with the rotational shaft 22 (see FIGS. 1 and 2) and all of the reaction vessels 13-1, 13-2, 13-3 rotated together along with the rotation of the rotational shaft 22. The other crystal growth conditions and rotation conditions were the same as those of Example 3.

The three reaction vessels 13-1, 13-2, 13-3 were thus coaxially installed, whereby, similarly to the case where the reaction vessel 13 was used alone, the mixed melt 6 was able to be caused to sufficiently flow around all of the seed crystals 7 in all of the reaction vessels 13-1, 13-2, 13-3 at the same time. In doing so, twelve high quality GaN crystals 5 were able to be produced at the same time to further increase the productivity.

Through the crystal growth process, twelve bulky GaN crystals 5 having a length in the c axis direction of 65 mm and a length in a direction vertical to the c axis direction of 55 mm were able to be manufactured at the same time. No miscellaneous crystal was produced and the GaN crystals 5 were not grown into polycrystals. When the manufactured bulky GaN crystals 5 were each sliced in parallel with the m plane and the c plane, and XRD measurement was performed thereon, it was revealed that the GaN crystal 5 had small variations in the FWHM and the peak position of XRC across the entire m plane and the entire c plane. The FWHM of XRC for the GaN crystal 5 in this case was 25 ± 5 arcsec both in the m plane and the c plane. The dislocation density of the obtained crystal was as low as 10⁴ cm⁻² or less, and the crystal was of high quality.

### Comparative Example 1

The present comparative example used a manufacturing apparatus different from the manufacturing apparatus 1 according to the present embodiment. In the present comparative example, GaN crystals 5 were grown using the reaction vessel 13 in which the seed crystals 7 and the structures 14B were installed as illustrated in FIGS. 14 and 15. The two structures 14B were installed asymmetrically with respect to the central axis 61 of the reaction vessel 13. The two seed crystals 7 were installed at the centers on the respective structures 14B. The seed crystals 7A were inserted in holes formed in the structures 14 to be held. The other crystal growth conditions and rotation conditions were the same as those of Example 2.

By this installation method of the structures 14B, when the reaction vessel 13 was rotated and stopped, upward flows from the outer region to the central region of the reaction vessel 13 were created asymmetrically with respect to the central axis 61. As a result, turbulence of flows was produced in the mixed melt 6 to produce a local highly supersaturated portion. Thus, the GaN crystals 5 were grown into polycrystals, miscellaneous crystals were additionally precipitated, and crystal growth rates varied among the crystal growth planes.

Through the crystal growth process, two bulky GaN crystals 5 having a length in the c axis direction of 50 mm and a length in a direction vertical to the c axis direction of 35 mm were able to be manufactured. 55% of the total yield was miscellaneous crystals and many parts of the GaN crystals 5 were grown into polycrystals. When the manufactured bulky GaN crystals 5 were each sliced in parallel with the m plane and the c plane, and XRD measurement was performed thereon, some parts thereof deteriorated to such a degree that the measurement of the FWHM of XRC was impossible, and many parts thereof had multiple peaks. The bulky GaN crystals 5 manufactured in the present comparative example had large variations across the entire m plane and the c plane.

As described above, the present embodiment can keep the mixed melt 6 uniform even when long-time growth is performed over a few hundred hours or longer. This enables a high-quality, large-sized group 13 nitride crystal to be manufactured.

An embodiment can provide a high-quality, large-sized group 13 nitride single crystal.

### REFERENCE SIGNS LIST

1 Apparatus for manufacturing group 13 nitride crystal (manufacturing apparatus)
5 Group 13 nitride crystal (GaN crystal)
6 Mixed melt
7, 7A, 7B, 7C, 7D, 7E, 7F Seed crystal
11 Pressure-resistant vessel
12 Internal vessel
13, 13-1, 13-2, 13-3 Reaction vessel
14, 14A, 14B Structure
15 Heater
16 Rotational mechanism
21 Turntable
22 Rotational shaft
31, 32, 33, 34, 35 Pipe
36, 37, 38, 39, 40 Valve
41, 42 Pressure controller
45 Pressure gauge
51, 55, 57 Side face
52 Inclined face
53, 56, 58 Top face
61 Central axis

### Citation List

### Patent Literature

Patent Literature 1: WO 2004/083498
Patent Literature 2: Patent Application Laid-open No. JP 2010-083711
Patent Literature 3: WO 2005/080648
Patent Literature 4: Patent Application Laid-open No. JP 2009-263162
Patent Literature 5: Patent Application Laid-open No. JP 2012-091958

## Claims

1. A method for manufacturing a group 13 nitride crystal by a flux method, the method comprising:
placing a seed crystal and a mixed melt that contains an alkali metal or an alkali-earth metal and a group 13 element in a reaction vessel; and
rotating the reaction vessel to stir the mixed melt, wherein
the reaction vessel includes a structure to stir the mixed melt,
more than one seed crystals are installed point-symmetrically with respect to a central axis of the reaction vessel at positions other than the central axis such that a c plane of each of the seed crystals is substantially parallel to a bottom of the reaction vessel, and
the structure is installed point-symmetrically with respect to the central axis in at least part of the reaction vessel other than the central axis.

2. The method for manufacturing a group 13 nitride crystal according to claim 1, wherein the seed crystals are grown such that point symmetry with respect to the central axis is maintained as a whole.

3. The method for manufacturing a group 13 nitride crystal according to claim 1 or 2, wherein the seed crystal is installed on the structure.

4. The method for manufacturing a group 13 nitride crystal according to claim 1 or 2, wherein the seed crystal is installed so as not to overlap with the structure.

5. The method for manufacturing a group 13 nitride crystal according to any one of claims 1 to 4, wherein the seed crystal is columnar.

6. The method for manufacturing a group 13 nitride crystal according to any one of claims 1 to 5, wherein a rotation axis of a rotational mechanism that rotates the reaction vessel coincides with the central axis.

7. The method for manufacturing a group 13 nitride crystal according to any one of claims 1 to 6, wherein the reaction vessel rotates so as to repeat rotation and stop.

8. The method for manufacturing a group 13 nitride crystal according to claim 7, wherein after the reaction vessel rotates and stops, the reaction vessel rotates in a direction opposite to a rotational direction before the stop.

9. The method for manufacturing a group 13 nitride crystal according to any one of claims 1 to 8, wherein the reaction vessel includes more than one reaction vessels and the reaction vessels are installed such that central axes of the reaction vessels coincide with the rotation axis.

10. The method for manufacturing a group 13 nitride crystal according to any one of claims 1 to 9, wherein the structure protrudes from one portion of the bottom of the reaction vessel toward an inside of the reaction vessel.

## Patentansprüche

1. Verfahren zum Herstellen eines Gruppe-13-Nitridkristalls mittels eines Fließverfahrens, wobei das Verfahren Folgendes umfasst:
Platzieren eines Impfkristalls und eines Schmelzegemischs, das ein Alkalimetall oder ein Alkalierdmetall und ein Gruppe-13-Element enthält, in ein Reaktionsgefäß und
Rotieren des Reaktionsgefäßes, um das Schmelzegemisch zu verrühren, wobei
das Reaktionsgefäß eine Struktur zum Verrühren des Schmelzegemischs beinhaltet,
mehr als ein Impfkristall mit Bezug auf eine Mittelachse des Reaktionsgefäßes in von der Mittelachse abweichenden Positionen punktsymmetrisch installiert sind, derart, dass eine c-Ebene des Impfkristalls im Wesentlichen parallel zu einem Boden des Reaktionsgefäßes verläuft, und
die Struktur mit Bezug auf die Mittelachse in mindestens einem von der Mittelachse abweichenden Teil des Reaktionsgefäßes punktsymmetrisch installiert ist.

2. Verfahren zum Herstellen eines Gruppe-13-Nitridkristalls nach Anspruch 1, wobei die Impfkristalle derart gezüchtet werden, dass mit Bezug auf die Mittelachse eine Punktsymmetrie als Ganzes beibehalten wird.

3. Verfahren zum Herstellen eines Gruppe-13-Nitridkristalls nach Anspruch 1 oder 2, wobei der Impfkristall auf der Struktur installiert wird.

4. Verfahren zum Herstellen eines Gruppe-13-Nitridkristalls nach Anspruch 1 oder 2, wobei der Impfkristall derart installiert wird, dass er die Struktur nicht überlappt.

5. Verfahren zum Herstellen eines Gruppe-13-Nitridkristalls nach einem der Ansprüche 1 bis 4, wobei der Impfkristall säulenförmig ist.

6. Verfahren zum Herstellen eines Gruppe-13-Nitridkristalls nach einem der Ansprüche 1 bis 5, wobei eine Rotationsachse eines Rotationsmechanismus, der das Reaktionsgefäß rotiert, mit der Mittelachse zusammenfällt.

7. Verfahren zum Herstellen eines Gruppe-13-Nitridkristalls nach einem der Ansprüche 1 bis 6, wobei das Reaktionsgefäß derart rotiert, dass es eine Rotation wiederholt und stehenbleibt.

8. Verfahren zum Herstellen eines Gruppe-13-Nitridkristalls nach Anspruch 7, wobei, nachdem das Reaktionsgefäß rotiert und stehengeblieben ist, das Reaktionsgefäß in eine Richtung rotiert, die einer Rotationsrichtung vor dem Stehenbleiben entgegengesetzt ist.

9. Verfahren zum Herstellen eines Gruppe-13-Nitridkristalls nach einem der Ansprüche 1 bis 8, wobei das Reaktionsgefäß mehr als ein Reaktionsgefäß beinhaltet und die Reaktionsgefäße derart installiert sind, dass die Mittelachsen der Reaktionsgefäße mit der Rotationsachse zusammenfallen.

10. Verfahren zum Herstellen eines Gruppe-13-Nitridkristalls nach einem der Ansprüche 1 bis 9, wobei die Struktur von einem Abschnitt des Bodens des Reaktionsgefäßes zu einer Innenseite des Reaktionsgefäßes vorsteht.

## Revendications

1. Procédé de fabrication d'un cristal de nitrure du groupe 13 par un procédé de flux, le procédé comprenant :
le placement d'un germe cristallin et d'un mélange fondu qui contient un métal alcalin ou un métal alcalino-terreux et un élément du groupe 13 dans une cuve de réaction ; et
la rotation de la cuve de réaction pour remuer le mélange fondu,
la cuve de réaction comprenant une structure pour remuer le mélange fondu,
plusieurs germes cristallins étant installés selon une symétrie ponctuelle par rapport à un axe central de la cuve de réaction dans des positions autres que l'axe central de manière qu'un plan c de chacun des germes cristallins est sensiblement parallèle à un fond de la cuve de réaction, et
la structure étant installée selon une symétrie ponctuelle par rapport à l'axe central dans au moins une partie de la cuve de réaction autre que l'axe central.

2. Procédé de fabrication d'un cristal de nitrure du groupe 13 selon la revendication 1, les germes cristallins étant cultivés de manière qu'une symétrie ponctuelle par rapport à l'axe central est maintenue dans son ensemble.

3. Procédé de fabrication d'un cristal de nitrure du groupe 13 selon la revendication 1 ou 2, dans lequel le germe cristallin est installé sur la structure.

4. Procédé de fabrication d'un cristal de nitrure du groupe 13 selon la revendication 1 ou 2, dans lequel le germe cristallin est installé de manière à ne pas chevaucher la structure.

5. Procédé de fabrication d'un cristal de nitrure du groupe 13 selon l'une quelconque des revendications 1 à 4, dans lequel le germe cristallin est en forme de colonne.

6. Procédé de fabrication d'un cristal de nitrure du groupe 13 selon l'une quelconque des revendications 1 à 5, dans lequel un axe de rotation d'un mécanisme de rotation qui fait tourner la cuve de réaction coïncide avec l'axe central.

7. Procédé de fabrication d'un cristal de nitrure du groupe 13 selon l'une quelconque des revendications 1 à 6, dans lequel la cuve de réaction tourne de manière à répéter la rotation et s'arrêter.

8. Procédé de fabrication d'un cristal de nitrure du groupe 13 selon la revendication 7, dans lequel après que la cuve de réaction a tourné et s'est arrêtée, la cuve de réaction tourne dans une direction opposée à une direction de rotation avant l'arrêt.

9. Procédé de fabrication d'un cristal de nitrure du groupe 13 selon l'une quelconque des revendications 1 à 8, dans lequel la cuve de réaction comprend plusieurs cuves de réaction et les cuves de réaction sont installées de manière que des axes centraux des cuves de réaction coïncident avec l'axe de rotation.

10. Procédé de fabrication d'un cristal de nitrure du groupe 13 selon l'une quelconque des revendications 1 à 9, dans lequel la structure fait saillie depuis une partie du fond de la cuve de réaction vers un côté intérieur de la cuve de réaction.
